(19) Europäisches Patentamt

European Patent Office

Office européen des brevets

(11) **EP 1 666 643 A1**

(12) **EUROPEAN PATENT APPLICATION**
published in accordance with Art. 158(3) EPC

(43) Date of publication:
**07.06.2006 Bulletin 2006/23**

(51) Int Cl.:
***C30B 15/00*** (1980.01)    ***C30B 29/06*** (1980.01)

(21) Application number: **04745518.3**

(22) Date of filing: **02.06.2004**

(86) International application number:
**PCT/JP2004/007619**

(87) International publication number:
**WO 2005/010242 (03.02.2005 Gazette 2005/05)**

(84) Designated Contracting States:
**DE**

(30) Priority: **29.07.2003 JP 2003282181**

(71) Applicant: **Shin-Etsu Handotai Co., Ltd
Tokyo 100-0005 (JP)**

(72) Inventor: **IIDA, Makoto,
c/o Shirakawa R & D Center
Nishishirakawa-gun,
Fukushima 961-8061 (JP)**

(74) Representative: **McBride, Peter Hill
Murgitroyd & Company
Scotland House
165-169 Scotland Street
Glasgow G5 8PL (GB)**

(54) **PROCESS FOR PRODUCING SINGLE CRYSTAL AND APPARATUS FOR SINGLE CRYSTAL PRODUCTION**

(57)     The present invention is a method for producing a single crystal by Czochralski method with pulling the single crystal from raw material melt in a crucible heated and melted by a heater, wherein the single crystal occupied by N region over an entire plane in a radial direction is produced with setting an inside diameter of the heater to be 1.26 or more times longer than an inside diameter of the crucible, and an apparatus for producing a single crystal by Czochralski method, at least, comprising a crucible for containing raw material melt, a heater surrounding the crucible so as to heat and melt the raw material melt in the crucible, and a pulling means for pulling the single crystal from the raw material melt in the crucible, wherein an inside diameter of the heater is 1.26 or more times longer than an inside diameter of the crucible. There is provided a method and an apparatus for producing a single crystal in which a pulling rate of producing a low-oxygen crystal occupied by N region can be increased, thereby productivity can be improved.

FIG.7

**Description**

Technical Field

The present invention relates to a method for producing a single crystal and an apparatus for producing a single crystal, more particularly, to a method for producing a single crystal with low oxygen concentration and with little defect in which defect is excluded over an entire radial direction of the crystal.

Background Technology

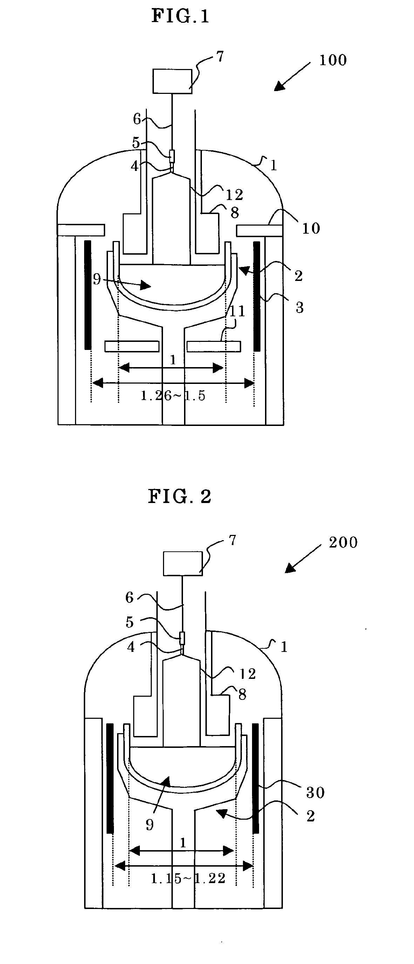

A silicon wafer used for semiconductor devices or the like is mainly grown by pulling method (Czochralski Method, CZ method). Czochralski Method (CZ method) has been commonly used to produce a single crystal. For example, an apparatus for producing a single crystal as shown in Fig.2 is used in Czochralski Method. The apparatus 200 for producing a single crystal has a crucible 2 for containing raw material melt 9 melted by a heater 30 in a chamber 1. The apparatus 200 also has a pulling means 7 for pulling a single crystal 12 from the raw material melt 9 in the crucible 2 with a wire 6 to which a seed holder 5 holding a seed crystal 4 at the tip is attached. A heat insulating member 8 is also provided to keep desired temperature distribution around the single crystal 12 to be pulled.

At the time of producing a single crystal, after an inert gas is introduced into the chamber 1, the wire 6 is extended from the pulling means 7 to immerse the seed crystal 4 held by the seed holder 5 into the raw material melt 9 in the crucible 2. Then, after immersing the seed crystal 4 in the raw material melt 9 for a moment, the wire 6 is wound at the prescribed rate with the pulling means 7 to grow the single crystal 12 beneath the seed crystal 4, thereby a single crystal ingot with a prescribed diameter is produced.

A diameter of the heater used in this case is designed so that the heater would not contact with the crucible or discharge would not be caused even if the crucible rotated eccentrically, or the crucible or the heater deformed. A diameter of the heater is also designed to diminish the diameter as much as possible in consideration of thermal efficiency and cost of the apparatus. Therefore, a ratio between an inside diameter of the crucible and an inside diameter of the heater has always fallen within 1:1.15 - 1.22 in a conventional apparatus for producing a single crystal as shown in Fig.2.

Such a silicon single crystal produced by CZ method is mainly used to produce semiconductor devices. In recent years, semiconductor devices have come to be integrated higher and devices have come to be finer. Involved with the tendency that devices have come to be finer, a problem of Grown-in defects introduced during growth of a single crystal has become more important.

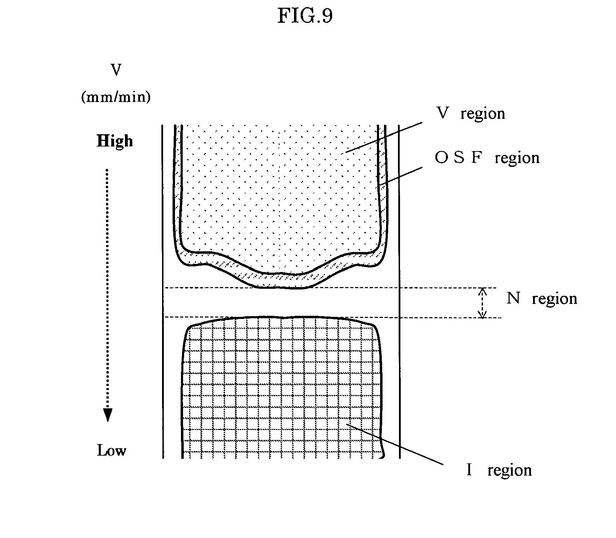

Hereafter, Grown-in defects will be explained with reference to Fig.9.

In the case of growing a silicon single crystal, when a growth rate of the crystal is relatively high, Grown-in defects such as FPD(Flow Pattern Defect) and COP(Crystal Originated Particle), which are considered due to voids consisting of agglomerated vacancy-type point defects, exist at a high density over the entire radial direction of the crystal. The region where these defects exist is referred to as V (Vacancy) region. Furthermore, when the growth rate of the crystal is lowered, along with lowering of the growth rate, an OSF (Oxidation Induced Stacking Fault) region is generated from the periphery of the crystal in a ring shape. When the growth rate is further lowered, the OSF ring shrinks to the center of the wafer and disappears. When the growth rate is further lowered, defects such as LSEPD (Large Secco Etch Pit Defect) and LFPD (Large Flow Pattern Defect), which are considered due to dislocation loops consisting of agglomerated interstitial silicon atoms, exist at a low density. The region where these defects exist is referred to as I (Interstitial) region.

In recent years, a region containing no defects like FPD and COP due to vacancy as well as no defects like LSEPD and LFPD due to interstitial silicon atoms has been found between the V region and the I region. This region is referred to as N (Neutral) region.

It is considered that introduction amount of these Grown-in defects is determined by a parameter of V/G which is a ratio of a pulling rate V to a temperature gradient G at the solid-liquid interface (for example, see V. V. Voronkov, Journal of Crystal Growth, 59 (1982), 625-643). Therefore, by controlling the pulling rate V and the temperature gradient G to keep V/G constant, a single crystal occupied by N region over an entire plane in a radial direction in which defect region is excluded over an entire radial direction of the crystal can be pulled.

On the other hand, a single crystal occupied by N region over an entire plane in a radial direction which has been demanded in recent years widely ranges from an extremely low-oxygen crystal containing oxygen at a concentration of 10 ppma (JEIDA:Japanese Electronic Industry Development Association Standard) or less to a high-oxygen crystal containing oxygen at a concentration of 18 ppma or more. Compared to the case of producing a high-oxygen crystal occupied by N region, a pulling rate tends to lower in the case of producing a low-oxygen crystal occupied by N region. For example, a pulling rate for pulling a single crystal occupied by N region over an entire plane in a radial direction containing oxygen at a concentration of 14 ppma lowers by about 10%, compared to a pulling rate for pulling a single crystal occupied by N region over an entire plane in a radial direction containing oxygen at a concentration of about 15-16 ppma. Then, decrease of productivity resulting from that has been recognized as a problem.

Especially, this tendency has been found in usual CZ method than in MCZ method. In CZ method, a heating center of a heater is commonly set to a higher position in comparison with raw material melt to achieve low oxygen concentration, and at this time heat is kept in the crystal. Then, G of a parameter V/G for controlling defect tends to lower, and V also lowers to produce a single crystal occupied by N region over an entire plane in a radial direction with keeping V/G constant.

In addition, there are parameters that can control oxygen concentration by changing the values of parameters besides a position of a heating center of a heater. However, because these parameters are often used to control defects when a single crystal occupied by N region over an entire plane in a radial direction is produced, the parameters usually can not be changed for controlling oxygen concentration. Therefore, development of a method that can improve productivity of a low-oxygen crystal occupied by N region has been desired.

Disclosure of the Invention

The present invention was accomplished in view of the aforementioned circumstances, and its object is to provide a method and an apparatus for producing a single crystal in which a pulling rate for producing a low-oxygen crystal occupied by N region can be increased to improve productivity.

The present invention was accomplished to achieve the aforementioned object, and there is provided a method for producing a single crystal by Czochralski method with pulling the single crystal from raw material melt in a crucible heated and melted by a heater, wherein the single crystal occupied by N region over an entire plane in a radial direction is produced with setting an inside diameter of the heater to be 1.26 or more times longer than an inside diameter of the crucible.

As described above, in a method for producing a single crystal by Czochralski method, a single crystal occupied by N region over an entire plane in a radial direction is produced with setting an inside diameter of the heater to be 1.26 or more times longer than an inside diameter of the crucible, namely with setting an inside diameter of the heater to be longer than that of a conventional apparatus. Thereby, a single crystal occupied by N region over an entire plane in a radial direction can be pulled at high rate, and productivity of a single crystal can be improved.

In this case, it is preferable that the single crystal is produced with setting an inside diameter of the heater to be 1.5 or less times longer than an inside diameter of the crucible.

As described above, by setting an inside diameter of the heater to be 1.5 or less times longer than an inside diameter of the crucible, consumption electric power of the heater can be reduced because thermal efficiency doesn't lower so much. Thereby, cost for producing a single crystal can be reduced. In addition, an apparatus doesn't need to be made large in size beyond necessity.

In these cases, it is possible that the single crystal is produced so as to contain oxygen at the concentration of 14 ppma or less.

As described above, in the production method of the present invention, a single crystal occupied by N region over an entire plane in a radial direction which contains oxygen at a low concentration of 14 ppma (JEIDA: Japanese Electronic Industry Development Association Standard) or less can be pulled at higher rate than in a conventional method, thereby productivity can be improved.

In these cases, it is possible that the single crystal is pulled without applying a magnetic field to the raw material melt.

As described above, the production method of the present invention achieves an effect particularly to produce a low-oxygen concentration single crystal occupied by N region over an entire plane in a radial direction without applying a magnetic field to the raw material melt.

In these cases, it is possible that a silicon single crystal is pulled as the single crystal.

The production method of the present invention is particularly suitable for producing a low-oxygen silicon single crystal occupied by N region over an entire plane in a radial direction that has been difficult to produce at a high level of productivity in the past.

In addition, the present invention provides an apparatus for producing a single crystal by Czochralski method, at least, comprising a crucible for containing raw material melt, a heater surrounding the crucible so as to heat and melt the raw material melt in the crucible, and a pulling means for pulling the single crystal from the raw material melt in the crucible, wherein an inside diameter of the heater is 1.26 or more times longer than an inside diameter of the crucible.

As described above, in the apparatus for producing a single crystal by Czochralski method of the present invention, an inside diameter of the heater is 1.26 or more times longer than an inside diameter of the crucible, and an inside diameter of the heater is larger than that of a conventional apparatus. Thereby, for example, a low-oxygen single crystal occupied by N region over an entire plane in a radial direction can be pulled at higher rate, and produced at a higher level of productivity.

In this case, it is preferable that an inside diameter of the heater is 1.5 or less times longer than an inside diameter of the crucible.

As described above, if an inside diameter of the heater is 1.5 or less times longer than an inside diameter of the crucible, thermal efficiency of the apparatus can be maintained and significant increase of consumption electric power of the heater can be prevented. In addition, the apparatus doesn't need to be made large in size beyond necessity.

As mentioned above, according to the present invention, particularly a low-oxygen crystal occupied by N region can be pulled at high rate approximately equal to pulling a high-oxygen crystal occupied by N region. Thereby, a low-oxygen crystal occupied by N region can be produced without deteriorating productivity. In addition, as operation time reduces, pulling the crystal can be completed before a crucible has deteriorated. Then, a ratio of obtaining a single crystal improves. And, not only a pulling rate but also yield improves, thereby considerable cost reduction can be achieved.

Brief Explanation of the Drawings

Fig. 1 is an explanatory view of an example of an apparatus for producing a single crystal of the present invention.
Fig. 2 is an explanatory view of an example of a conventional apparatus for producing a single crystal.
Fig. 3 is a graph showing a relationship between a ratio of an inside diameter of a heater to an inside diameter of a crucible ,and a pulling rate that can pull a single crystal occupied by N region over an entire plane in a radial direction in respect to a silicon single crystal with low oxygen concentration of 14 ppma.
Fig. 4 is a graph showing a relationship between a ratio of an inside diameter of a heater to an inside diameter of a crucible ,and a position of heating center of a heater.
Fig. 5 is a graph showing a relationship between a ratio of an inside diameter of a heater to an inside diameter of a crucible ,and a maximum temperature Tmax of raw material melt.
Fig. 6 is a graph showing pulling rate of single crystals in the Examples and the Comparative Example.
Fig. 7 is a graph showing oxygen concentration of single crystals in the Examples and the Comparative Example.
Fig. 8 is a graph showing a range of a value of V/G and Tmax to obtain a single crystal occupied by N region.
Fig. 9 is an explanatory view showing a relationship between a growth rate and a distribution of crystal defects.

Best Mode for Carrying out the Invention

Hereinafter, embodiments of the present invention will be explained in detail.

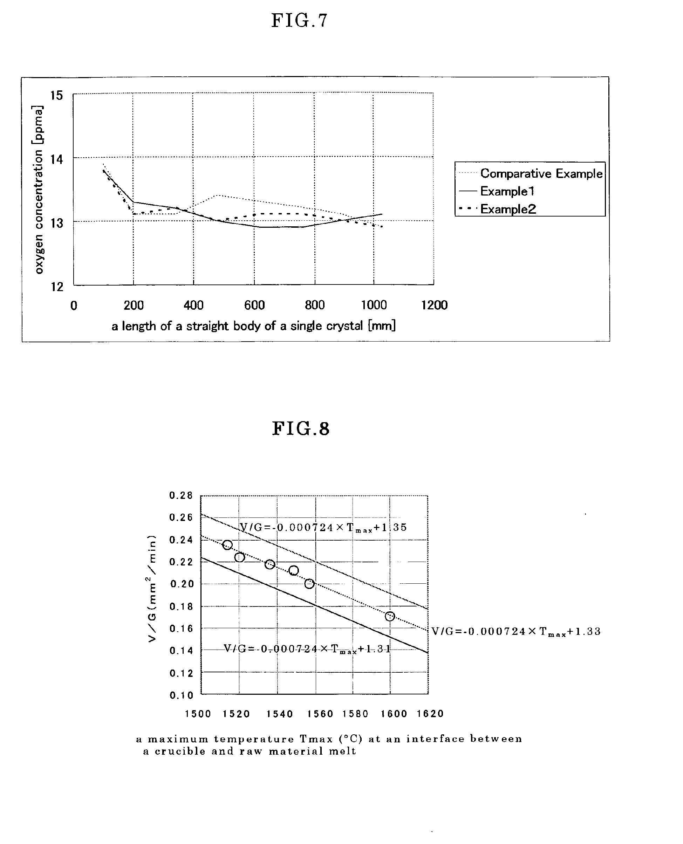

The present inventors performed thorough investigations as to conditions to produce a single crystal occupied by N region over an entire plane in a radial direction. Consequently, they have found that a maximum temperature Tmax (°C) at an interface between a crucible and raw material melt (a maximum temperature of raw material melt) besides a pulling rate V (mm/min) and a temperature gradient G (K/mm) at a solid-liquid interface is a parameter having an enormous effect on pulling a single crystal occupied by N region over an entire plane in a radial direction. And they have examined for a range of a value of V/G and Tmax to obtain a single crystal occupied by N region. Fig. 8 is a graph showing a range of a value of V/G and Tmax in which a single crystal occupied by N region over an entire plane in a radial direction can be obtained. As shown in Fig.8, for example, it has been proposed that a single crystal can be pulled with controlling a value of V/G (mm$^2$/K · min) within a range from -0.000724 x Tmax + 1.31 to -0.000724 x Tmax + 1.35 to surely produce a single crystal occupied by N region over an entire plane in a radial direction (see Japanese Patent Application No. 2003-135085).

Then, the present inventors have investigated for correlation between the value of V/G and Tmax. Consequently, they considered that even if G lowers to some extent by positioning a heater at upper portion of raw material melt to obtain a single crystal with low oxygen concentration, by lowering a temperature Tmax of the raw material melt ,pulling rate V that can obtain a single crystal occupied by N region need not lower so much. And they have performed thorough experiments and simulations as to a furnace structure (hot zone: HZ) having such a thermal distribution.

As a result, they have found that expansion of a diameter of a heater compared to a conventional apparatus has remarkable effect on satisfying both lowering temperature of raw material melt (then Tmax lowers, thereby a pulling rate can be increased.) and positioning a heating center of a heater at higher position (then oxygen concentration in a single crystal lowers). They have also found that this method enables production of a low-oxygen single crystal occupied by N region over an entire plane in a radial direction at relatively higher rate even in usual CZ method without applying a magnetic field.

As described above, in a conventional apparatus, a diameter of a heater compared to a diameter of a crucible has been designed to diminish as much as possible in consideration of thermal efficiency and downsizing an apparatus. Therefore, there have been no idea to set an inside diameter of a heater to be a large diameter of 1.26 or more times longer than an inside diameter of a crucible.

However, for example, let us consider the case of pulling a single crystal with satisfying a formula,

$$V/G = -0.000724 \times Tmax + 1.33 \qquad (1)$$

which tells in Fig.8 a range that can pull a single crystal occupied by N region over an entire plane in a radial direction (See the dashed line in Fig.8). The formula leads to the following formula as to a pulling rate V.

$$V = (-0.000724 \times Tmax + 1.33) \times G \qquad (2)$$

In this case, if a heating center of a heater is positioned at upper portion of raw material melt to obtain a low-oxygen concentration crystal, heat is kept in the crystal and G lowers, thereby V also lowers. However, if Tmax is lowered by setting a heater to be larger than a crucible in diameter, a value in the parenthesis on righthand side of the formula (2) becomes larger even if G decreases to some extent. Thereby, it is presumed that a value of pulling rate V can be increased.

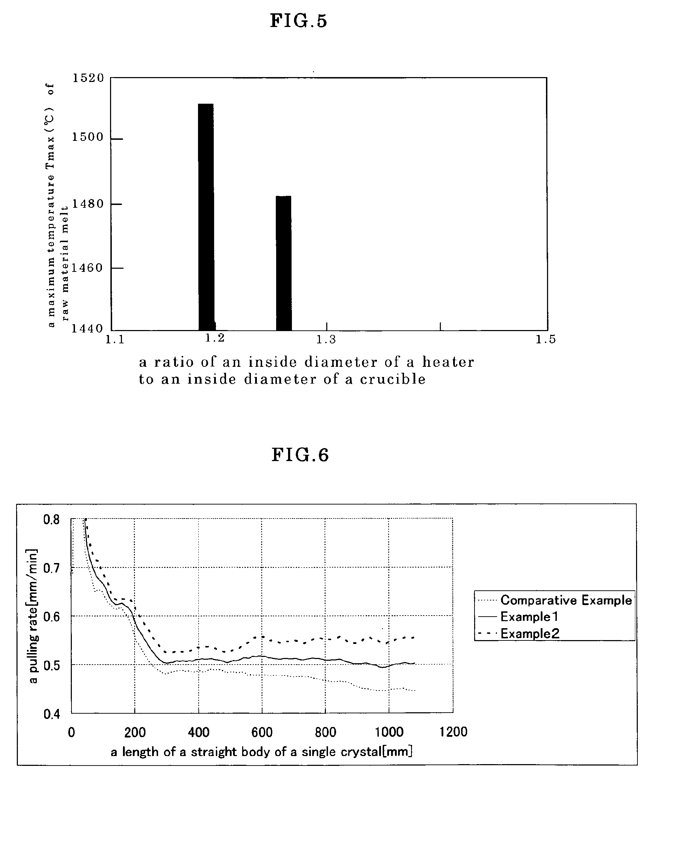

Then, the present inventors actually fabricated apparatuses with various ratios of an inside diameter of a heater to an inside diameter of a crucible, and performed experiments and simulations to examine for characteristics of the apparatuses. Fig. 4 shows distances from bottom of a crucible to a position of a heating center of a heater (a position of a maximum temperature in raw material melt) in a conventional apparatus whose ratio of an inside diameter of a heater to an inside diameter of a crucible is 1.19, and in an apparatus in which a diameter of a heater is expanded whose ratio of an inside diameter of a heater to an inside diameter of a crucible is 1.264. As shown in Fig.4, while a heating center of the apparatus whose ratio of an inside diameter of a heater to an inside diameter of a crucible is 1.19 is 32.01 cm from the bottom of the crucible, a heating center of the apparatus whose ratio of an inside diameter of the heater to an inside diameter of the crucible is 1.264 is 32.40 cm. Therefore, it is found that a heating center of a heater can be positioned at upper portion of raw material melt even in an apparatus in which a diameter of a heater is expanded, thereby a crystal with low oxygen concentration can be produced.

On the other hand, Fig. 5 shows results of measuring Tmax of both apparatuses mentioned above. As shown in Fig.5, while Tmax of the apparatus whose ratio of an inside diameter of a heater to an inside diameter of a crucible is 1.19 is 1514 °C, Tmax of the apparatus in which a diameter of a heater is expanded whose ratio of an inside diameter of a heater to an inside diameter of a crucible is 1.264 is 1483 °C, which turns out to be lower than the former by 31 °C.

Consequently, it is found that expanding a ratio of an inside diameter of a heater to an inside diameter of a crucible to be larger than that of a conventional apparatus enables both lowering temperature of raw material melt (lowering Tmax) and positioning a heating center of a heater at upper portion.

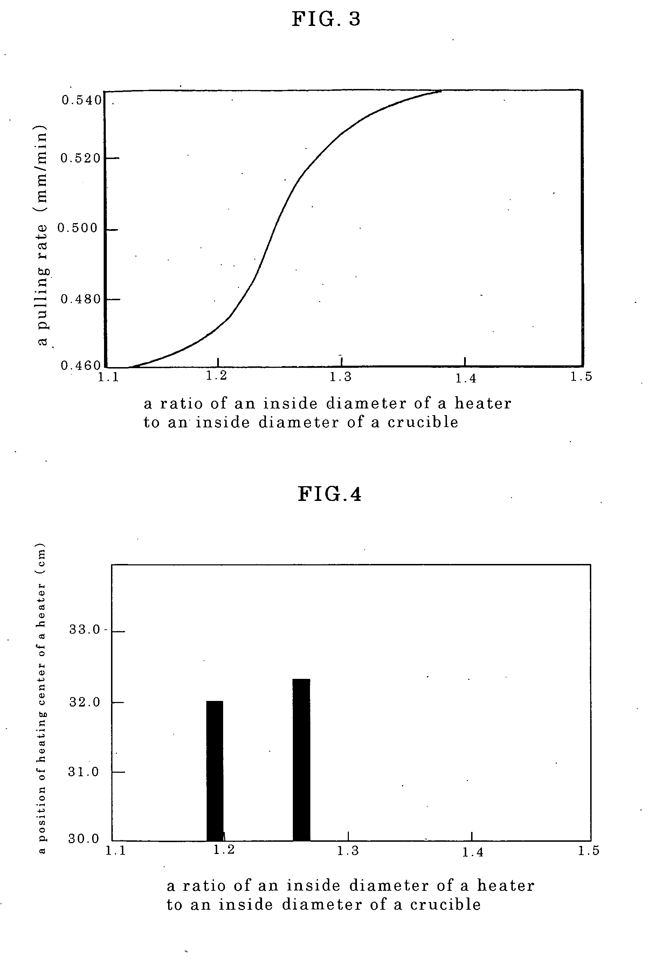

Then, the present inventors performed investigations and examinations as to a pulling rate V that can pull a single crystal occupied by N region over an entire plane in a radial direction with apparatuses having various ratios of an inside diameter of a heater to an inside diameter of a crucible. Fig. 3 is a graph showing a relationship between a ratio of an inside diameter of the heater to an inside diameter of the crucible ,and a pulling rate that can pull a single crystal occupied by N region over an entire plane in a radial direction in respect to a silicon single crystal with low oxygen concentration of 14 ppma. As shown in Fig.3, it is found that a pulling rate V (mm/min) that can pull a single crystal occupied by N region increases when a ratio of an inside diameter of the heater to an inside diameter of the crucible is approximately 1.26 or more. Therefore, by setting a ratio of an inside diameter of the heater to an inside diameter of the crucible to be 1.26 or more, a low-oxygen crystal occupied by N region can be pulled at higher rate than conventional methods, thereby the crystal can be produced at a high level of productivity.

Hereinafter, an apparatus and a method for producing a single crystal according to the present invention will be explained in detail with reference to the drawings. Fig. 1 is an explanatory view of an example of an apparatus for producing a single crystal of the present invention.

An apparatus 100 for producing a single crystal of the present invention has a heater 3, a crucible 2 for containing raw material melt 9 therein, and a pulling means 7 for pulling a single crystal 12 with a wire 6 to which a seed holder 5 holding a seed crystal 4 at the tip is attached in a chamber 1, just like the above-mentioned apparatus in Fig.2. And a heat insulating member 8 is also provided to keep desired temperature distribution around the single crystal 12 to be pulled. The feature of the apparatus 100 of the present invention is setting an inside diameter of the heater 3 to be 1.26 or more times longer than an inside diameter of the crucible 2 as shown in Fig.1. Therefore, a maximum temperature Tmax (°C) of raw material melt can be made lower than in a conventional apparatus, thereby a pulling rate V can be increased. Furthermore, a position of a heating center of the heater 3 can be set at upper portion of the raw material melt 9, thereby a crystal with low oxygen concentration can be obtained. Therefore, a low-oxygen single crystal occupied by N region over an entire plane in a radial direction can be produced at a high rate.

In addition, it is preferable to set an inside diameter of the heater 3 to be 1.5 or less times longer than an inside diameter of the crucible 2. Therefore, deterioration of thermal efficiency can be prevented and an apparatus doesn't need to be made large in size beyond necessity. Furthermore, in order to change V/G or Tmax to prescribed values, an upper heat insulating material 10 above a heater to keep heat of upper portion of the heater 3, or a heat insulating crucible support 11 to keep heat under the crucible 2 may be provided as shown in Fig. 1.

And, when a single crystal 12 is actually pulled with the apparatus 100, for example, a value of G or Tmax is controlled to be in a range that can obtain a single crystal occupied by N region over an entire plane in a radial direction in the above-mentioned Fig.8. Then, a single crystal can be pulled with a pulling rate V that satisfies the conditions.

(Example 1)

A silicon single crystal occupied by N region over an entire plane in a radial direction with oxygen concentration of 13 ppma (JEIDA) was grown without applying a magnetic field to a raw material melt in an apparatus as shown in Fig.1, in which an inside diameter of a crucible was 538mm, an inside diameter of a heater was 680mm, and a ratio of an inside diameter of the crucible and an inside diameter of the heater was 1.264. The single crystal with low oxygen concentration was grown with a state of a thermal distribution in a furnace in which a distance between bottom of the crucible and a position of the maximum temperature in raw material melt (a heating center of the heater) was 32cm. At this time, the maximum temperature Tmax of the raw material melt was 1483 °C, and a temperature gradient G at a solid-liquid interface was 20.1 [K/cm]. A pulling rate of the pulled single crystal occupied by N region is shown in Fig. 6, and oxygen concentration of the crystal is shown in Fig. 7. As shown in Fig.7, oxygen concentration of a straight body of the single crystal was low oxygen concentration of approximately 13 ppma. As shown in Fig.6, an average pulling rate of the straight body of the single crystal was 0.515 [mm/min]. The pulling rate was the same as the case of which performed pulling a crystal with oxygen concentration of 15 ppma with the apparatus of the Example 1.

(Example 2)

A single crystal occupied by N region over an entire plane in a radial direction with oxygen concentration of 13 ppma was grown without applying a magnetic field to raw material melt in an apparatus as shown in Fig.1, in which an inside diameter of a crucible was 538mm, an inside diameter of a heater was 720mm, and a ratio of an inside diameter of the crucible and an inside diameter of the heater was 1.34. The single crystal with low oxygen concentration was grown with a state of a thermal distribution in a furnace in which a distance between the bottom of the crucible and a position of the maximum temperature in the raw material melt (a heating center of the heater) was 32cm. At this time, the maximum temperature Tmax of the raw material melt was 1468 °C, and a temperature gradient G at a solid-liquid interface was 20.05 [K/cm]. A pulling rate of the pulled single crystal occupied by N region is shown in Fig. 6, and oxygen concentration of the crystal is shown in Fig. 7. As shown in Fig.7, oxygen concentration of a straight body of the single crystal was low oxygen concentration of approximately 13 ppma. As shown in Fig.6, an average pulling rate of the straight body of the single crystal was 0.535 [mm/min]. The pulling rate was the same as the case of which performed pulling a crystal with oxygen concentration of 16 ppma with the apparatus of the Example 2.

(Comparative Example)

A single crystal occupied by N region over an entire plane in a radial direction with oxygen concentration of 13 ppma was grown without applying a magnetic field to raw material melt in a standard apparatus as shown in Fig.2, in which an inside diameter of a crucible was 538mm, an inside diameter of a heater was 640mm, and a ratio of an inside diameter of the heater and an inside diameter of the crucible was 1.19. The single crystal with low oxygen concentration was grown with a state of a thermal distribution in a furnace in which a distance between the bottom of the crucible and a position of the maximum temperature in raw material melt (a heating center of the heater) was 32cm. At this time, the maximum temperature Tmax of the raw material melt was 1514 °C, and a temperature gradient G at a solid-liquid interface was 20.2 [K/cm]. A pulling rate of the pulled single crystal occupied by N region is shown in Fig. 6, and oxygen concentration of the crystal is shown in Fig. 7. As shown in Fig.7, oxygen concentration of a straight body of the single crystal was low oxygen concentration of approximately 13 ppma. However, as shown in Fig.6, an average pulling rate of the straight body of the single crystal was low rate of 0.47 (mm/min).

In addition, the present invention is not limited to the embodiment described above. The above-described embodiment is mere an example, and those having substantially the same structure as technical ideas described in the appended claims and providing the similar functions and advantages are included in the scope of the present invention.

For example, the present invention is applicable regardless of absolute values of diameter of a crucible and a heater. Especially, the diameter will become much larger in the days to come and it is presumed that a temperature of crucible wall will become higher. In such a case, the present invention can be applied more effectively.

**Claims**

1.  A method for producing a single crystal by Czochralski method with pulling the single crystal from raw material melt in a crucible heated and melted by a heater, wherein the single crystal occupied by N region over an entire plane in a radial direction is produced with setting an inside diameter of the heater to be 1.26 or more times longer than an inside diameter of the crucible.

2.  The method for producing a single crystal according to Claim 1, wherein the single crystal is produced with setting an inside diameter of the heater to be 1.5 or less times longer than an inside diameter of the crucible.

3.  The method for producing a single crystal according to Claim 1 or Claim 2, wherein the single crystal is produced so as to contain oxygen at the concentration of 14 ppma or less.

4.  The method for producing a single crystal according to any one of Claims 1 - 3, wherein the single crystal is pulled without applying a magnetic field to the raw material melt.

5.  The method for producing a single crystal according to any one of Claims 1 - 4, wherein a silicon single crystal is pulled as the single crystal.

6.  An apparatus for producing a single crystal by Czochralski method, at least, comprising a crucible for containing raw material melt, a heater surrounding the crucible so as to heat and melt the raw material melt in the crucible, and a pulling means for pulling the single crystal from the raw material melt in the crucible, wherein an inside diameter of the heater is 1.26 or more times longer than an inside diameter of the crucible.

7.  The apparatus for producing a single crystal according to Claim 6, wherein an inside diameter of the heater is 1.5 or less times longer than an inside diameter of the crucible.

## FIG.1

## FIG. 2

## FIG. 3

a ratio of an inside diameter of a heater
to an inside diameter of a crucible

## FIG.4

a ratio of an inside diameter of a heater
to an inside diameter of a crucible

# FIG.5

a maximum temperature Tmax (℃) of raw material melt

1520
1500
1480
1460
1440

1.1    1.2    1.3    1.5

a ratio of an inside diameter of a heater
to an inside diameter of a crucible

# FIG.6

a pulling rate[mm/min]

0.8
0.7
0.6
0.5
0.4

0    200    400    600    800    1000    1200

a length of a straight body of a single crystal[mm]

········· Comparative Example
——— Example 1
– – – Example 2

EP 1 666 643 A1

FIG.7

FIG.8

FIG.9

V
(mm/min)

High

Low

V region

O S F region

N region

I region

## INTERNATIONAL SEARCH REPORT

| | International application No. |
|---|---|
| | PCT/JP2004/007619 |

**A. CLASSIFICATION OF SUBJECT MATTER**
Int.Cl⁷  C30B15/00, C30B29/06

According to International Patent Classification (IPC) or to both national classification and IPC

**B. FIELDS SEARCHED**

Minimum documentation searched (classification system followed by classification symbols)
Int.Cl⁷  C30B15/00, C30B29/06

Documentation searched other than minimum documentation to the extent that such documents are included in the fields searched

| Jitsuyo Shinan Koho | 1926–1996 | Toroku Jitsuyo Shinan Koho | 1994–2004 |
|---|---|---|---|
| Kokai Jitsuyo Shinan Koho | 1971–2004 | Jitsuyo Shinan Toroku Koho | 1996–2004 |

Electronic data base consulted during the international search (name of data base and, where practicable, search terms used)
WPI, Elsevier

**C. DOCUMENTS CONSIDERED TO BE RELEVANT**

| Category* | Citation of document, with indication, where appropriate, of the relevant passages | Relevant to claim No. |
|---|---|---|
| X | WO 2002-000970 A1 (Shin-Etsu Handotai Co., Ltd.), 03 January, 2002 (03.01.02), Claims; page 10, line 22 to page 14, line 8 (Family: none) | 1-7 |
| A | JP 2002-137987 A (Sumitomo Metal Industries, Ltd.), 14 May, 2002 (14.05.02), Claims; page 4, Par. No. [0033] to page 5, Par. No. [0041] (Family: none) | 1-7 |

☐ Further documents are listed in the continuation of Box C.   ☐ See patent family annex.

| | | |
|---|---|---|
| \* | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| 13 August, 2004 (13.08.04) | 31 August, 2004 (31.08.04) |

| Name and mailing address of the ISA/ | Authorized officer |
|---|---|
| Japanese Patent Office | |
| Facsimile No. | Telephone No. |

Form PCT/ISA/210 (second sheet) (January 2004)